**Europäisches Patentamt**

**European Patent Office**

**Office européen des brevets**

(19)

(11) Veröffentlichungsnummer: **0 110 257**
**B1**

# EUROPÄISCHE PATENTSCHRIFT

(12)

(45) Veröffentlichungstag der Patentschrift:
24.02.88

(21) Anmeldenummer: 83111516.7

(22) Anmeldetag: 17.11.83

(51) Int. Cl.⁴: **G 01 R 31/28, H 04 Q 9/14**

(54) Schaltungsanordnung zur Adressierung von Baugruppen.

(30) Priorität: 29.11.82 DE 3244061

(43) Veröffentlichungstag der Anmeldung:
13.06.84 Patentblatt 84/24

(45) Bekanntmachung des Hinweises auf die Patenterteilung:
24.02.88 Patentblatt 88/8

(84) Benannte Vertragsstaaten:
AT CH DE FR IT LI NL SE

(56) Entgegenhaltungen:
EP-A-0 050 292
EP-A-0 063 650
DE-A-2 335 824
DE-A-3 041 811
DE-A-3 110 614
US-A-3 784 910

(73) Patentinhaber: Siemens Aktiengesellschaft Berlin
und München, Wittelsbacherplatz 2, D-8000
München 2 (DE)

(72) Erfinder: Kollet, René, Dipl.- Ing., 2, rue du
Cyclalamens, F-67630 Neewiller- Pres- Lauterb. (FR)

**0 110 257**

**Beschreibung**

Die Erfindung betrifft eine Schaltungsanordnung zur Adressierung von Baugruppen mit an den einzelnen Baugruppen angeordneten Adressenempfängern.

Die US-Patentschrift 3 784 910 beschreibt ein in einander untergeordneten Ebenen anwählbares Verdrahtungsprüfsystem. Derartige Prüfsysteme dienen beispielsweise dazu, die ordnungsgemäße Verdrahtung einer Vielzahl von Verdrahtungsstützpunkten festzustellen. Einzelne dieser Vielzahl von Stützpunkten sind durch Verdrahtungszüge zu Netzwerken verbunden. Die fehlerfreie Verbindung der Verdrahtungsstützpunkte dieser Netzwerke und deren gegenseitige Isolierung müssen für jeden Verdrahtungsstützpunkt nachgeprüft werden. Dazu müssen die Verdrahtungsstützpunkte, die gleichzeitig die Prüfpunkte eines Prüflings bilden, einzeln anwählbar sein. Oft handelt es sich um eine Anzahl von Prüfpunkten in der Größenordnung von 100 000 oder mehr. Müßte eine solche Anzahl von Prüfpunkten unmittelbar angewählt werden, so wären dazu bei paralleler Adressierung sehr viele Leitungen erforderlich, die den Prüfpunkten zugeordnete Prüfpunktschaltkreise des Prüfsystems mit dem Interface eines Rechners zu verbinden hätten. Eine serielle Adressierung würde sehr viel Zeit erfordern. In der erwähnten US-Patentschrift wird deshalb eine hierarchische Adressierung vorgeschlagen. Dabei werden jeweils acht den Prüfpunkten zugeordnete Prüfschaltkreise zusammengefaßt und diese Gruppenschaltkreise jeweils mit einem eigenen Decodierer zum Adressieren der Prüfschaltkreise versehen. Von diesen Achtergruppen werden dann jeweils wieder dreizehn zu einer Baugruppe zusammengefaßt, die ihrerseits wieder einen eigenen Decodierer zur Adressierung ihrer Gruppenschaltkreise enthält. Die Baugruppen selbst sind beim Gegenstand der US-Patentschrift seriell adressierbar. Als Adressenempfänger, die an der Baugruppe angeordnet sind, dienen jeweils zwei Stufen eines Schieberegisters. Durch das Verschieben eines Eingangssignals des Schieberegisters mit einer Taktimpulsfolge werden die einzelnen Baugruppen der Reihe nach angewählt oder adressiert.

Beim bekannten Stand der Technik wirkt die Ansteuerung der einzelnen Baugruppen durch ein Schieberegister wie eine Anwahl durch einen Drehschalter. Es kann keine Baugruppe angewählt werden, ohne daß vorher die vorausgehenden Baugruppen angewählt worden sind. Die Geschwindigkeit ist außerdem abhängig von der Taktimpulsfrequenz.

Mit der Erfindung sollte eine Schaltungsanordnung zur Adressierung von Baugruppen geschaffen werden, mit der einzelne Baugruppen selektiv angewählt werden können, ohne daß dazu ein bei einer großen Anzahl von Baugruppen aufwendiger Decodierer notwendig wird.

Eine erste Lösung dieser Aufgabe ist bei einer eingangs genannten Schaltungsanordnung gemäß der Erfindung dadurch gekennzeichnet, daß die Empfänger aus additiven Verknüpfungsgliedern mit zwei Eingängen für ein codiertes Adressensignal einerseits und ein für alle Empfänger gleiches digitales Änderungssignal andererseits und zwei Ausgängen für das nach Maßgabe der Verknüpfung und des Änderungssignals veränderte Adressensignal einerseits und für ein einem vorgegebenen Wert des im Empfänger veränderten Adressensignals entsprechendes decodiertes Signal andererseits bestehen und die Adressensignalausgänge von vorhergehenden Empfängern mit den Adressensignaleingängen von nachfolgenden Empfängern verbunden sind.

Mit der Schaltungsanordnung nach der Erfindung ist eine selektive Anwahl einzelner Baugruppen möglich, ohne daß dafür ein Decodierer mit ebenso vielen Ausgängen wie Baugruppen erforderlich wird. Die für die Anwahl benötigte Zeit ist nicht mehr abhängig von der Taktfrequenz einer Taktimpulsfolge für ein Schieberegister, sondern nur noch von der Laufzeit der Signale durch die additiven Verknüpfungsglieder, die den einzelnen Baugruppen zugeordnet sind.

Bei einem Ausführungsbeispiel der Erfindung bestehen die additiven Verknüpfungsglieder aus Subtrahierern. Der der ersten Baugruppe zugeordnete Adressenempfänger erhält ein codiertes Adressensignal, das aus der Ordnungszahl des anzuwählenden Empfängers besteht. Das für jeden Empfänger gleiche Änderungssignal besteht aus dem gesetzten Bit geringster Wertigkeit. Als decodiertes Signal dient der Wert Null des veränderten Adressensignals, der als Ergebnis der Subtraktion im Subtrahierer des angewählten Empfängers auftritt.

Als decodiertes Signal kann auch das Signal Borrow = 1 des Subtrahierers verwendet werden, das in dem auf den angewählten Empfänger folgenden Empfänger auftritt. Um dieses Signal für die gleiche Adresse zu benutzen, muß das in den ersten Empfänger eingegebene codierte Adressensignal aus der Ordnungszahl des anzuwählenden Empfängers weniger Eins bestehen.

Bei einem anderen Ausführungsbeispiel der Erfindung sind Addierer als additive Verknüpfungsglieder in den Adressenempfängern verwendet. Das dem ersten Empfänger bei diesem Ausführungsbeispiel aufgegebene codierte Adressensignal besteht aus der zur Ordnungszahl des anzuwählenden Empfängers bezüglich der Anzahl der Empfänger komplementären Zahl. Das Änderungssignal besteht aus dem gesetzten Bit geringster Wertigkeit, und das decodierte Signal wird aus einem der Anzahl der Empfänger entsprechenden Wert des veränderten Adressensignals gebildet. Dabei ist vorausgesetzt, daß die Bitbreite des Addierers gleich der Anzahl der anwählbaren Empfänger ist. Bei einer etwas abgeänderten Betriebsweise besteht das dem ersten Empfänger aufgegebene codierte Adressensignal aus der zur Ordnungszahl des anzuwählenden Empfängers bezüglich der Anzahl der Empfänger komplementären Zahl, die jedoch um Eins vermehrt ist. Das decodierte Signal wird dann aus dem Signal Carry = 1 des Addierers abgeleitet.

Bei einer weiteren Lösung der gestellten Aufgabe weist eine Erfindung Empfänger auf, die je einen

2

0 110 257

Vergleicher und einen Subtrahierer umfassen. An einen von zwei Eingängen jedes Vergleichers ist dabei parallel ein codiertes Adressensignal gelegt. Der andere Eingang jedes Vergleichers ist mit dem Ausgang des ihm zugeordneten Subtrahierers verbunden, an dessen Minuendeneingang jeweils der Ausgang des Subtrahierers eines vorhergehenden Empfängers angeschlossen ist. An den Subtrahendeneingängen aller Subtrahierer ist das Bit geringster Wertigkeit gesetzt. Dabei ist an den Minuendeneingang des ersten der hintereinandergeschalteten Subtrahierer immer die höchste Adresse plus Eins gelegt. Bei Übereinstimmung der im Vergleicher miteinander verglichenen Signale gibt dieser ein decodiertes Signal ab.

Die Erfindung wird an drei Figuren erläutert, die jeweils Blockschaltbilder dreier Ausführungsformen der Erfindung darstellen.

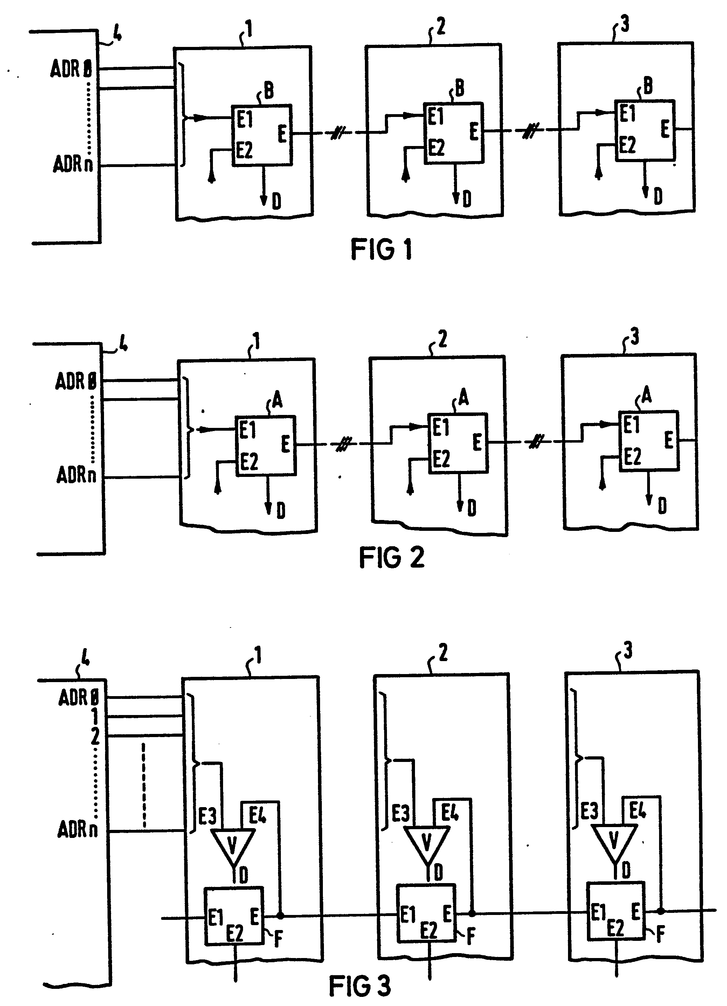

In Figur 1 sind drei Baugruppen 1, 2 und 3 eines Verdrahtungsprüfers über ein Interface 4 eines Mikroprozessors, der zum Verdrahtungsprüfer gehört, anwählbar. Die zweite Baugruppe steht stellvertretend für mehrere Baugruppen, die zwischen der ersten Baugruppe 1 und der letzten Baugruppe 3 liegen. Die Adressen für die Baugruppen weisen jeweils n Bits auf, die Zahl n richtet sich dabei nach der Anzahl der Baugruppen. Die Baugruppen 1... 3 können über Adressenempfänger angewählt werden, die auf den Baugruppen angeordnet sind. Die Adressenempfänger bestehen aus additiven Verknüpfungsgliedern B mit jeweils zwei Eingängen E1 und E2 und zwei Ausgängen E und D. Die Ausgänge E von vorhergehenden Adressenempfängern sind mit n Bitleitungen mit den Eingängen E1 von nachfolgenden Adressenempfängern verbunden. Der Eingang E1 des ersten Adressenempfängers steht mit den Bitausgängen des Interface 4 in Verbindung. Die additiven Verknüpfungsglieder B, aus denen die Adressenempfänger bestehen, sind im Ausführungsbeispiel nach der Figur 1 Subtrahierer. Die Eingänge E1 sind dabei die Minuendeneingänge und die Eingänge E2 die Subtrahendeneingänge. An den Eingängen E1 liegen jeweils das Adressensignal bzw. nach der ersten Baugruppe das veränderte Adressensignal. An den Eingängen E2 ist jeweils das Bit geringster Wertigkeit gesetzt. Am Ausgang D liegt im Falle der adressierten Baugruppe ein vorgegebener Wert des im Empfänger veränderten Adressensignals als decodiertes Signal an.

Soll z. B. mit einem 8 Bit umfassenden Adressensignal die fünfte Baugruppe adressiert werden, so lautet die Adresse in binärer Schreibweise:

ADR = 0 0 0 0 0 1 0 1

Am Adressenempfänger der Baugruppe 1 liegen dann folgende Signale:

| am Eingang E1 | 0 0 0 0 0 1 0 1 | (5) |
| am Eingang E2 | 0 0 0 0 0 0 0 1 | (1) |
| am Ausgang E  | 0 0 0 0 0 1 0 0 | (4) |

In Klammern sind jeweils die dekadischen Werte der binären Signale angegeben.

Für die zweite Baugruppe liegt

| am Signaleingang E1 | 0 0 0 0 0 1 0 0 | (4) |
| am Signaleingang E2 | 0 0 0 0 0 0 0 1 | (1) |
| am Ausgang E        | 0 0 0 0 0 0 1 1 | (3) |

Für die fünfte Baugruppe sind die Signale

| am Eingang E1 | 0 0 0 0 0 0 0 1 | (1) |
| am Eingang E2 | 0 0 0 0 0 0 0 1 | (1) |
| am Ausgang E  | 0 0 0 0 0 0 0 0 | (0) |

Für eine sechste Baugruppe liegen

| am Eingang E1 | 0 0 0 0 0 0 0 0 | (0) |
| am Eingang E2 | 0 0 0 0 0 0 0 1 | (1) |

In der folgenden Tabelle sind für die Adressenempfänger der ersten bis sechsten Baugruppe Signale angegeben, die an einem an den Adressenempfängern der Figur nicht dargestellten dritten Ausgang Borrow und an dem Ausgang E anliegen.

|            | Borrow | E         |
| ---------- | ------ | --------- |
| Baugruppe 1. | 0    | $\neq 0$  |
| Baugruppe 2. | 0    | $\neq 0$  |
| Baugruppe 5. | 0    | $= 0$     |
| Baugruppe 6. | 1    | $\neq 0$  |

Aus dieser Tabelle ist ersichtlich, daß das Decodiersignal am Ausgang D des Adressenempfängers der angewählten Baugruppe sowohl aus dem Signal E = 0 als auch aus dem Signal Borrow = 1 abgeleitet werden kann. Im ersten Fall stimmt die adressierte Baugruppe mit der decodierten Baugruppe überein. Im zweiten Fall

3

muß das ursprüngliche Adressensignal um Eins vermindert werden, um die anzuwählende Baugruppe zu erreichen.

Das Ausführungsbeispiel nach der Figur 2 stimmt äußerlich weitgehend mit dem Ausführungsbeispiel nach der Figur 1 überein, jedoch ist das als Adressenempfänger den einzelnen Baugruppen zugeordnete additive Verknüpfungsglied A beim Ausführungsbeispiel nach der Figur 2 ein Addierer. Als dem Eingang E1 des ersten Adressenempfängers zugeführtes codiertes Adressensignal dient die zur Ordnungszahl des anzuwählenden Empfängers bezüglich der Anzahl der Empfänger komplementäre Zahl. Am Eingang E2 ist wieder das Bit geringster Wertigkeit gesetzt. Der Ausgang E eines vorhergehenden Empfängers ist mit dem Eingang E1 eines nachfolgenden Empfängers verbunden. Am Ausgang D ist ein decodiertes Signal abnehmbar, das einem der Anzahl der Empfänger entsprechenden Wert des veränderten Adressensignals entspricht.

Soll z. B. mit einem 8 Bit umfassenden Adressensignal die fünfte Baugruppe einer Schaltungsanordnung nach Figur 2 adressiert werden, so lautet die Adresse in binärer Schreibweise:

ADR = 0 0 0 0 0 1 0 1

An den Eingängen E1 und E2 sowie am Ausgang E des Adressenempfängers der Baugruppe 1 liegen dann folgende Signale:

| | | |
|---|---|---|
| am Eingang E1 | 1 1 1 1 1 0 1 0 | (250) |
| am Eingang E2 | 0 0 0 0 0 0 0 1 | (1) |
| am Ausgang E | 1 1 1 1 1 0 1 1 | (251) |

In Klammern sind jeweils wieder die dekadischen Werte der binären Signale angegeben.
Bei der zweiten Baugruppe liegt

| | | |
|---|---|---|
| am Signaleingang E1 | 1 1 1 1 1 0 1 1 | (252) |
| am Signaleingang E2 | 0 0 0 0 0 0 0 1 | (1) |
| am Ausgang E | 1 1 1 1 1 1 0 0 | (252) |

Für die fünfte Baugruppe lauten die entsprechenden Signale:

| | | |
|---|---|---|
| am Eingang E1 | 1 1 1 1 1 1 1 0 | (254) |
| am Eingang E2 | 0 0 0 0 0 0 0 1 | (1) |
| am Ausgang E | 1 1 1 1 1 1 1 1 | (255) |

Bei einer sechsten Baugruppe liegen

| | | |
|---|---|---|
| am Eingang E1 | 1 1 1 1 1 1 1 1 | (255) |
| aam Eingang E2 | 0 0 0 0 0 0 0 1 | (1) |
| am Ausgang E | 0 0 0 0 0 0 0 0 | (0) |

In der folgenden Tabelle sind für die Adressenempfänger der ersten bis sechsten Baugruppe (wobei die dritte und vierte Baugruppe der Einfachheit halber weggelassen wurde) Signale angegeben, die an einem an den Adressenempfängern der Figur 2 nicht dargestellten dritten Ausgang Carry und an dem Ausgang E anliegen. Für den Ausgang E wurden der kürzeren Schreibweise wegen dekadische Zahlen verwendet.

| | Carry | E |
|---|---|---|
| Baugruppe 1. | 0 | ≠ 255 |
| Baugruppe 2. | 0 | ≠ 255 |
| Baugruppe 5. | 0 | = 255 |
| Baugruppe 6. | 1 | ≠ 255 |

Aus der Tabelle ist ersichtlich, daß das Decodiersignal am Ausgang D des Adressenempfängers der angewählten Baugruppe sowohl aus dem Signal E = 255, also der bei 8 Bit höchstmöglichen Adresse, als auch aus dem Signal Carry = 1 der auf die anzuwählende Baugruppe nächstfolgenden Baugruppe abgeleitet werden kann. Im zweiten Fall muß jedoch das in den Adressenempfänger der ersten Baugruppe einzuspeisende codierte Adressensignal um Eins vermehrt werden, damit die anzuwählende Baugruppe erreicht wird.

Auch in der Figur 3 sind drei Baugruppen 1, 2 und 3 eines Verdrahtungsprüfers über ein Interface 4 eines Mikroprozessors, der zum Verdrahtungsprüfer gehört, anwählbar. Die Adressen für die Baugruppen weisen jeweils n Bits auf, die Zahl n richtet sich dabei nach der Anzahl der Baugruppen. Die Baugruppen 1... 3 können über Adressenempfänger angewählt werden, die auf den Baugruppen angeordnet sind. Die Adressenempfänger bei diesem Ausführungsbeispiel der Erfindung bestehen aus je einem Vergleicher V und einem additiven Verknüpfungsglied F. Das Verknüpfungsglied F ist ein Subtrahierer. An Eingängen E3 der Vergleicher V liegen parallel Bitausgänge des Interface 4 für das Adressensignal. Der Ausgang E der additiven Verknüpfungsglieder F ist jeweils mit einem zweiten Eingang E4 des zugeordneten Vergleichers verbunden. Außerdem liegen die Ausgänge E von vorangehenden additiven Verknüpfungsgliedern an den Eingängen E1 nachfolgender Verknüpfungsglieder. An Eingängen E2, den Subtrahendeneingängen der additiven

4

0 110 257

Verknüpfungsglieder F, ist jeweils das Bit geringster Wertigkeit gesetzt. An den Eingang E1 des der Baugruppe 1 zugeordneten additiven Verknüpfungsgliedes ist ein Signal gelegt, das der größtmöglichen Adresse plus Eins entspricht. Das Resultat der Subtraktion in jedem additiven Verknüpfungsglied F wird mit dem am Eingang E3 des entsprechenden Vergleichers V liegenden Adressensignal verglichen. Bei übereinstimmenden Signalen gibt der Vergleicher V an seinem Ausgang D ein decodiertes Signal ab.

**Patentansprüche**

1. Schaltungsanordnung zur Adressierung von Baugruppen mit an den einzelnen Baugruppen angeordneten Adressenempfängern, <u>dadurch gekennzeichnet</u>, daß die Empfänger aus additiven Verknüpfungsgliedern (B, A) mit zwei Eingängen (E1, E2) für ein codiertes Adressensignal einerseits und ein für alle Empfänger gleiches digitales Änderungssignal andererseits und zwei Ausgängen (E, D) für das nach Maßgabe der Verknüpfung und des Änderungssignals veränderte Adressensignal einerseits und für ein einem vorgegebenen Wert des im Empfänger veränderten Adressensignals entsprechendes decodiertes Signal andererseits bestehen und die Adressensignalausgänge (E) von vorhergehenden Empfängern mit den Adressensignaleingängen (E1) von nachfolgenden Empfängern verbunden sind.

2. Schaltungsanordnung nach Anspruch 1, <u>dadurch gekennzeichnet</u>, daß die Verknüpfungsglieder (B) Subtrahierer sind, das dem ersten Empfänger aufgegebene codierte Adressensignal aus der Ordnungszahl des anzuwählenden Empfängers und das Änderungssignal aus dem gesetzten Bit geringster Wertigkeit besteht und daß das decodierte Signal dem Wert Null des veränderten Adressensignals entspricht.

3. Schaltungsanordnung nach Anspruch 2, dahingehend abgeändert, daß das dem ersten Empfänger aufgegebene codierte Adressensignal aus der um Eins verminderten Ordnungszahl des anzuwählenden Empfängers besteht und daß das decodierte Signal aus dem Signal Borrow = 1 des Subtrahierers abgeleitet ist.

4. Schaltungsanordnung nach Anspruch 1, <u>dadurch gekennzeichnet</u>, daß die Verknüpfungsglieder (A) Addierer sind, das dem ersten Empfänger aufgegebene codierte Adressensignal aus der zur Ordnungszahl des anzuwählenden Empfängers bezüglich der Anzahl der Empfänger komplementären Zahl und das Änderungssignal aus dem gesetzten Bit geringster Wertigkeit besteht und daß das decodierte Signal einem der Anzahl der Empfänger entsprechenden Wert des veränderten Adressensignals entspricht.

5. Schaltungsanordnung nach Anspruch 4, dahingehend abgeändert, daß das dem ersten Empfänger aufgegebene codierte Adressensignal aus der zur Ordnungszahl des anzuwählenden Empfängers bezüglich der Anzahl der Empfänger komplementären Zahl, die um Eins vermehrt ist, besteht und daß das decodierte Signal aus dem Signal Carry = 1 des Addierers abgeleitet ist.

6. Schaltungsanordnung zur Adressierung von Baugruppen mit an den einzelnen Baugruppen angeordneten Adressenempfängern, <u>dadurch gekennzeichnet</u>, daß die Empfänger je einen Vergleicher (V) und einen Subtrahierer (F) umfassen und an einen (E3) von zwei Eingängen jedes Vergleichers (V) parallel ein codiertes Adressensignal gelegt ist und der andere Eingang (E4) jedes Vergleichers (V) mit dem Ausgang (E) des ihm zugeordneten Subtrahierers (F) verbunden ist, an dessen Minuendeneingang (E1) jeweils der Ausgang (E) des Subtrahierers (F) eines vorhergehenden Empfängers angeschlossen ist und an den Subtrahendeneingängen (E2) aller Subtrahierer (F) das Bit geringster Wertigkeit gesetzt ist, wobei an den Minuendeneingang (E1) des ersten der hintereinandergeschalteten Subtrahierer (F) immer die höchste Adresse plus Eins gelegt ist, und daß der Ausgang (D) des Vergleichers (V) bei Übereinstimmung der verglichenen Signale ein decodiertes Signal abgibt.

**Claims**

1. A circuit arrangement for addressing assemblies with address receivers arranged at the individual assemblies, <u>characterised in</u> that the receivers comprise an additive logic-linking component (B, A) having two inputs (E1, E2) for a coded address signal on the one hand and for a digital change signal, identical for all receivers, on the other hand, and having two outputs (E, D) on the one hand for the address signal which is changed in accordance with the logic-linking and the change signal and on the other hand for a decoded signal which corresponds to a predetermined value of the address signal which is changed in the receiver, and that the address signal outputs (E) of preceding receivers are connected to the address signal inputs (E1) of following receivers.

2. A circuit arrangement as claimed in claim 1, <u>characterised in</u> that the logic-linking components (B) are subtractors, the coded address signal which is supplied to the first receiver comprises the ordinal number of the receiver which is to be selected and the change signal comprises the lowest value set bit, and that the decoded signal corresponds to the zero value of the changed address signal.

3. A circuit arrangement as claimed in claim 2, modified to the extent that the coded address signal which is supplied to the first receiver comprises the ordinal number, reduced by one, of the receiver which is to be selected, and that the decoded signal is derived from the borrow = 1 signal of the subtractor.

5

0 110 257

4. A circuit arrangement as claimed in claim 1, <u>characterised in</u> that the logic-linking elements (A) are adders, the coded address signal which is supplied to the first receiver comprises the number which is complementary to the ordinal number of the receiver which is to be selected, relative to the number of receivers, and the change signal comprises the lowest value set bit, and that the decoded signal corresponds to a value, corresponding to the number of receivers, of the changed address signal.

5. A circuit arrangement as claimed in claim 4, modified to the extent that the coded address signal which is supplied to the first receiver comprises the number which is complementary to the ordinal number of the receiver to be selected, relative to the number of receivers, increased by one, and that the decoded signal is derived from the carry = 1 signal of the adder.

6. A circuit arrangement for addressing assemblies with address receivers arranged at the individual assemblies, <u>characterised in</u> that the receivers each comprise a comparator (E) and a subtractor (F) and that a coded address signal is connected in parallel to one (E3) of two inputs of each comparator (E), and the other input (E4) of each comparator (E) is connected to the output (E) of the subtractor (F) which is assigned thereto and whose minuend input (E1) is in each case connected to the output (E) of the subtractor (F) of a preceding receiver and where the lowest value bit is set at the subtrahend inputs (E2) of all the subtractors (F), where the highest address plus one is always applied to the minuend input (E1) of the first of the series connected subtractors (F) and that in the event that the compared signals are identical the output (D) of the comparator (E) emits a decoded signal.

**Revendications**

1. Montage pour réaliser l'adressage de modules comportant des récepteurs d'adresses, disposés dans les différents modules, caractérisé par le fait que les récepteurs sont constitués par des circuits logiques additifs (B, A) comportant deux entrées (E1, E2) pour un signal d'adresse codé d'une part et pour un signal numérique de modification, égal pour tous les récepteurs, d'autre part et deux sorties (E, D) pour le signal d'adresse modifié en fonction de la combinaison logique et du signal de modification, d'une part et pour un signal décodé, correspondant à une valeur prédéterminée du signal d'adresse modifié dans le récepteur, d'autre part et que les sorties (E) des signaux d'adresses de récepteurs situés en amont sont reliées aux entrées (E) des signaux d'adresses de récepteurs situés en aval.

2. Montage suivant la revendication 1, caractérisé par le fait que les circuits logiques (B) sont des soustracteurs, que le signal codé d'adresse, envoyé au premier récepteur, est constitué par le nombre ordinal du récepteur devant être sélectionnés, que le signal de modification est constitué par le bit positionné possédant le poids le plus faible et que le signal décodé correspond à la valeur nulle du signal d'adresse modifié.

3. Montage suivant la revendication 2, modifié en ce sens que le signal codé d'adresse, envoyé au premier récepteur, est constitué par le nombre ordinal, diminué de un, du récepteur devant être sélectionné et que le signal décodé est dérivé du signal retenue = 1 du soustracteur.

4. Montage suivant la revendication 1, caractérisé par le fait que les circuits logiques (A) sont des additionneurs, que le signal codé d'adresse, envoyé au premier récepteur, est constitué par le nombre complémentaire, par rapport au nombre de récepteurs, du nombre ordinal du récepteur devant être sélectionné, que le signal de modification est constitué par le bit positionné de poids le plus faible et que le signal décodé correspond à une valeur, correspondant au nombre de récepteurs, du signal d'adresse modifié.

5. Montage suivant la revendication 4, modifié en ce sens que le signal codé d'adresse, envoyé au premier récepteur, est constitué par le nombre, qui est complémentaire, par rapport au nombre de récepteur, du nombre ordinal du récepteur devant être sélectionné et est accru de un, et que le signal décodé est dérivé du signal report = 1 de l'additionneur.

6. Montage pour réaliser l'adressage de modules comportant des récepteurs d'adresses disposés dans les différents modules, caractérisé par le fait que les récepteurs comportent chacun un comparateur (V) et un soustracteur (F) et qu'un signal codé d'adresse est appliqué en parallèle à l'une (E3) de deux entrées des différents comparateurs (V) et que l'autre entrée (E4) de chaque comparateur (V) est reliée à la sortie (E) du soustracteur (F), qui lui est associé et à l'entrée (E1) du minuende duquel est raccordée respectivement la sortie (E) du soustracteur (F) du récepteur situé en amont, et que le bit de poids le plus faible est appliqué aux entrées (E) des nombres à soustraire, de tous les soustracteurs (F), auquel cas l'adresse maximale plus un est toujours appliquée à l'entrée (E1) du minuende du premier des soustracteurs (F) branchés en série, et que la sortie (E) du comparateur (V) délivre un signal décodé dans le cas d'une coïncidence des signaux comparés.

6

0 110 257

FIG 1

FIG 2

FIG 3